(19) Europäisches Patentamt
European Patent Office
Office européen des brevets

(11) EP 1 867 675 A1

(12) EUROPEAN PATENT APPLICATION
published in accordance with Art. 158(3) EPC

(43) Date of publication:
**19.12.2007 Bulletin 2007/51**

(21) Application number: **06730931.0**

(22) Date of filing: **27.03.2006**

(51) Int Cl.:
***C08J 5/18*** *(2006.01)*
***B29C 41/24*** *(2006.01)*
***B29C 55/12*** *(2006.01)*
***C08G 73/10*** *(2006.01)*
***B29K 79/00*** *(2006.01)*
***B29L 7/00*** *(2006.01)*
***C08L 79/08*** *(2006.01)*

(86) International application number:
**PCT/JP2006/306983**

(87) International publication number:
**WO 2006/104228 (05.10.2006 Gazette 2006/40)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **28.03.2005 JP 2005091924**
**10.06.2005 JP 2005170857**

(71) Applicant: **Teiken Limited**
**Osaka-shi, Osaka 541-0054 (JP)**

(72) Inventors:
- **ISHIWATA, Toyoaki**
  **inodecho, Iwakuni-shi, Yamaguchi, 740001 (JP)**
- **MATSUO, Jyuhou**
  **ahigaoka 4-chome, Hino-shi, Tokyo, 19100 (JP)**
- **KIDO, Nobuaki**
  **iyoda-ku, Tokyo, 1000011 (JP)**

(74) Representative: **Hallybone, Huw George et al**
**Carpmaels and Ransford**
**43-45 Bloomsbury Square**
**London WC1A 2RA (GB)**

# (54) AROMATIC POLYIMIDE FILM AND METHOD FOR PRODUCING SAME

(57) This invention aims to provide an aromatic polyimide film having a specific elastic modulus and a specific coefficient of thermal expansion and a process for the production thereof.

This invention is directed to an aromatic polyimide film that is formed of an aromatic polyimide containing at least 70 mol% of a recurring unit of the following formula (I),

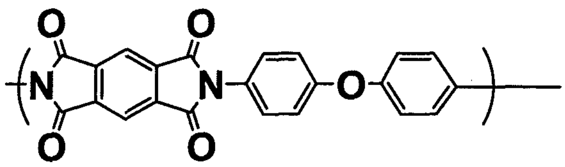

(I)

and that satisfies the following expressions (1) and (2),

$$CTE^{MD} \leqq -11 \times Mi^{MD} + 70 \quad (1)$$

$$CTE^{TD} \leqq -11 \times Mi^{TD} + 70 \quad (2)$$

wherein $CTE^{MD}$ is a coefficient of in-plane thermal expansion (ppm · $K^{-1}$) in the machine direction,
$CTE^{TD}$ is a coefficient of in-plane thermal expansion (ppm · $K^{-1}$) in the transverse direction,
$Mi^{MD}$ is an elastic modulus (GPa) in the machine direction, and
$Mi^{TD}$ is an elastic modulus (GPa) in the transverse direction, and a process for the production thereof.

EP 1 867 675 A1

## Description

### Technical Field

This invention relates to an aromatic polyimide film having a specific elastic modulus and a specific thermal expansion coefficient and a process for the production thereof. More specifically, it relates to an aromatic polyimide film for use as a support on which a metal foil typified by a copper foil or a metal thin film is to be stacked to form an electric wiring board and a process for the production thereof.

### Background Art

Being excellent in heat resistance and mechanical properties, an aromatic polyimide film is widely used as a substrate material for a flexible printed circuit (FPC) for an electronic machine or instrument such as a camera, a personal computer or a liquid crystal display or as a substrate material for tape-automated bonding (TAB). When an aromatic polyimide film is used as a substrate material, a copper foil is bonded thereto with an adhesive such as an epoxy resin.

As recent years have found strong demands for downsizing and higher density of electronic machines and instruments, there is a demand for a film having a smaller thickness and having excellent dimensional stability. In particular when a flexible printed circuit is made, a film is used in a state where it is bonded to a copper foil, so that the film is required to have stability against a change in temperature during solder re-flowing. In particular when the thickness of a substrate is decreased, a film causes a problem against decreasing the distortion of the substrate during or after a production step since the thermal expansion coefficient thereof differs from that of copper, and improvements have been proposed with regard to the structure of an aromatic polyimide.

As the above aromatic polyimide film, for example, there has been proposed an aromatic polyimide film that has an in-plane anisotropy index of 20 or less and an average coefficient of in-plane thermal expansion (CTE) smaller than the counterpart of a non-oriented film by at least 10 % and that is biaxially oriented to be isotropic and to have an in-plane orientation coefficient of 0.11 or more (Patent Document 1).
(Patent Document 1) JP-A 5-237928

### Disclosure of the Invention

It is an object of this invention to provide an aromatic polyimide film which causes almost no or little distortion when it has a thermal expansion caused by a change in temperature while it is used together with copper bonded thereto, and a process for the production thereof.

It is another object of this invention to provide an aromatic polyimide film rich in flexibility while it has a small coefficient of in-plane thermal expansion and a process for the production thereof.

The present inventor has made studies with regard to the relationship between the stretch ratio and coefficient of in-plane thermal expansion of an aromatic polyimide film. As a result, it has been found that an aromatic polyimide film having a small coefficient of in-plane thermal expansion and having excellent dimensional stability can be obtained by stretching a gel film at a high ratio that no conventional art has employed. And this invention was accomplished by this finding.

Further, the present inventor has studied the stretchability of a gel film and in particular has brought into focus the imidation index and swelling degree of a gel film that is stretched. As a result it has been found that when the imidation index of a gel film is brought into a specific range, the stretch ratios in the machine direction and the transverse direction can be set as required, and that there can be obtained a film having a small coefficient of in-plane thermal expansion as compared with a conventional aromatic polyimide film having an equivalent elastic modulus. This invention has been accordingly completed. Further, it has been found that when the swelling degree of a gel film is brought into a specific range, a still superior result can be obtained.

This invention provides an aromatic polyimide film that is formed of an aromatic polyimide containing at least 70 mol% of a recurring unit of the following formula (I),

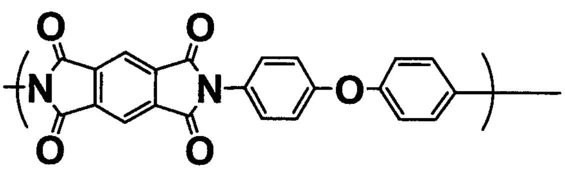

(I)

and that satisfies the following expressions (1) and (2),

$$CTE^{MD} \leqq -11 \times Mi^{MD} + 70 \quad (1)$$

$$CTE^{TD} \leqq -11 \times Mi^{TD} + 70 \quad (2)$$

wherein $CTE^{MD}$ is a coefficient of in-plane thermal expansion (ppm · $K^{-1}$) in the machine direction,
$CTE^{TD}$ is a coefficient of in-plane thermal expansion (ppm · $K^{-1}$) in the transverse direction,
$Mi^{MD}$ is an elastic modulus (GPa) in the machine direction, and

$Mi^{TD}$ is an elastic modulus (GPa) in the transverse direction.

Further, this invention provides a process for the production of the above aromatic polyimide film, which comprises the steps of:

(1) reacting an aromatic tetracarboxylic acid (component A) containing at least 70 mol% of pyromellitic anhydride with an aromatic diamine (component B) containing at least 70 mol% of 4,4'-diaminodiphenyl ether, in an organic solvent, in the range of 0.95≤component A/component B (molar ratio)≤1.05, to obtain a dope of a polyamic acid containing at least 70 mol% of a recurring unit derived from the pyromellitic acid and the 4,4'-diaminodiphenyl ether,
(2) casting the dope on a support to obtain a cast film,
(3) immersing the cast film in a coagulating liquid containing an imidation agent at 20 to 70°C and thereby imidating the polyamic acid to obtain a gel film,
(4) stretching the gel film at least 1.4 times as long in the machine direction and at least 1.4 times as wide in the transverse direction, to obtain a biaxially stretched gel film, and
(5) drying and heat-treating the biaxially stretched gel film.

Best Mode for Embodiments of the Invention

This invention will be explained in detail hereinafter.

<Aromatic polyimide film>

The aromatic polyimide film of this invention is formed of an aromatic polyimide containing at least 70 mol%, preferably 90 to 100 mol%, more preferably 95 to 100 mol%, of a recurring unit of the following formula (I).

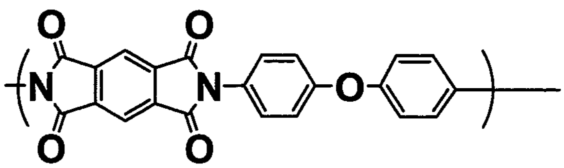

(I)

For satisfying moisture absorption, flexibility and the relationship between the elastic modulus and the coefficient of in-plane thermal expansion, defined by the expressions (1) and (2), the content of the recurring unit of the formula (I) is preferably at least 70 mol%. For satisfying the relationship defined by the formula (1) and (2), it is preferred to ensure that the aromatic polyimide has a larger content of the recurring unit of the above formula (I).

The aromatic polyimide can be produced by reacting an aromatic tetracarboxylic acid component mainly containing pyromellitic acid and an aromatic diamine component mainly containing 4,4'-diaminodiphenyl ether. The recurring unit of the formula (I) is a recurring unit derived from pyromellitic acid and 4,4'-diaminodiphenyl ether. The content of other recurring unit different from the recurring unit of the formula (I) is 30 mol% or less, preferably 0 to 10 mol%, more preferably 0 to 5 mol%.

Examples of other aromatic tetracarboxylic acid component that constitutes the other recurring unit different from the recurring unit of the formula (I) include 1,2,3,4-benzenetetracarboxylic acid, 2,3,5,6-pyridinetetracarboxylic acid, 2,3,4,5-thiophenetetracarboxylic acid, 2,2',3,3'-benzophenonetetracarboxylic acid, 2,3',3,4'-benzophenonetetracarboxylic acid, 3,3',4,4'-benzophenonetetracarboxylic acid, 3,3',4,4'-biphenyltetracarboxylic acid, 2,2',3,3'-biphenyltetracarboxylic acid, 2,3,3',4'-biphenyltetracarboxylic acid, 3,3',4,4'-p-terphenyltetracarboxylic acid, 2,2',3,3'-p-terphenyltetracarboxylic acid, 2,3,3',4'-p-terphenyltetracarboxylic acid, 1,2,4,5-naphthalenetetracarboxylic acid, 1,2,5,6-naphthalenetetracarboxylic acid, 1,2,6,7-naphthalenetetracarboxylic acid, 1,4,5,8-naphthalenetetracarboxylic acid, 2,3,6,7-naphthalenetetracarboxylic acid, 2,3,6,7-anthracenetetracarboxylic acid, 1,2,5,6-anthracenetetracarboxylic acid, 1,2,6,7-phenanthrenetetracarboxylic acid, 1,2,7,8-phenanthrenetetracarboxylic acid, 1,2,9,10-phenanthrenetetracarboxylic acid, 3,4,9,10-perylenetetracarboxylic acid, 2,6-dichloronaphthalene-1,4,5,8-tracarboxylic acid, 2,7-dichloronaphthalene-1,4,5,8-tracarboxylic acid, 2,3,6,7-tetrachloronaphthalene-1,4,5,8-tracarboxylic acid, 1,4,5,8-tetrachloronaphthalene-2,3,6,7-tracarboxylic acid, bis(2,3-dicarboxyphenyl)ether, bis(3,4-dicarboxyphenyl)ether, bis(2,3-dicarboxyphenyl)methane, bis(3,4-dicarboxyphenyl)methane, bis(2,3-dicarboxyphenyl)sulfone, bis(3,4-dicarboxyphenyl)sulfone, 1,1-bis(2,3-dicarboxyphenyl)ethane, 1,1-bis(3,4-dicarboxyphenyl)ethane, 2,2-bis(2,3-dicarboxyphenyl)propane, 2,2-bis(3,4-dicarboxyphenyl)propane, 2,6-bis(3,4-dicarboxyphenyl)pyridine, 1,1,1,3,3,3-hexafluoro-2,2-bis(3,4-dicarboxyphenyl)propane and bis(3,4-dicarboxyphenyl)dimethylsilane. Further, two or more compounds out of these aromatic tetracarboxylic acid components may be used at the same time.

Of these, 3,3',4,4'-benzophenonetetracarboxylic acid and 3,3',4,4'-biphenyltetracarboxylic acid are preferred as the "other" aromatic tetracarboxylic acid components.

Examples of other aromatic diamine component that constitutes the other recurring unit different from the recurring unit of the formula (I) include 1,3-phenylenediamine, 1,4-diaminonaphthalene, 1,5-diaminonaphthalene, 1,8-diaminonaphthalene, 2,6-diaminonaphthalene, 2,7-diaminonaphthalene, 2,6-diaminoanthracene, 2,7-diaminoanthracene, 1,8-diaminoanthracene, 2,4-diaminotoluene, 2,5-diamino(m-xylene), 2,5-diaminopyridine, 2,6-diaminopyridine, 3,5-diaminopyridine, 2,4-diaminotoluenebenzidine, 3,3'-diaminobiphenyl, 3,3'-dichlorobenzidine, 3,3'-dimethylbenzidine, 3,3'-dimethoxybenzidine, 2,2'-diaminobenzophenone, 4,4'-diaminobenzophenone, 3,3'-diaminodiphenyl ether, 3,4'-diaminodiphenyl ether, 3,3'-diaminodiphenylmethane, 4,4'-diaminodiphenylmethane, 4,4'-diaminodiphenylmethane, 3,4'-diaminodiphenylsulfone, 4,4'-diaminodiphenylsulfone, 3,3'-diaminodiphenylsulfide, 3,4'-diaminodiphenylsulfide, 4,4'-diaminodiphenylsulfide, 4,4'-diaminodiphenyl thioether, 4,4'-diamino-3,3',5,5'-tetramethyl diphenyl ether, 4,4'-diamino-3,3',5,5'-tetraethyl diphenyl ether, 4,4'-diamino-3,3',5,5'-tetramethyldiphenylmethane, 1,3-bis(3-aminophenoxy)benzene, 1,3-bis(4-aminophenoxy)benzene, 1,4-bis(3-aminophenoxy)benzene, 1,4-bis(4-aminophenoxy)benzene, 2,6-bis(3-aminophenoxy)pyridine, 1,4-bis(3-aminophenylsulfonyl)benzene, 1,4-bis(4-aminophenylsulfonyl)benzene, 1,4-bis(3-aminophenylthioether)benzene, 1,4-bis(4-aminophenylthioether)benzene, 4,4'-bis(3-aminophenoxy) diphenylsulfone, 4,4'-bis(4-aminophenoxy)diphenylsulfone, bis(4-aminophenyl)amine, bis(4-aminophenyl)-N-methylamine, bis(4-aminophenyl)-N-phenylamine, bis(4-aminophenyl)phosphine oxide, 1,1-bis(3-aminophenyl)ethane, 1,1-bis (4-aminophenyl)ethane, 2,2-bis(3-aminophenyl)propane, 2,2-bis(4-aminophenyl)propane, 2,2-bis(4-amino-3,5-dimethylphenyl)propane, 4,4'-bis(4-aminophenoxy)biphenyl, bis[4-(3-aminophenoxy)phenyl]sulfone, bis [4- (4-aminophenoxy) phenyl] sulfone, bis[4-(4-aminophenoxy)phenyl]ether, bis[4-(4-aminophenoxy)phenyl]methane, bis[3-methyl-4-(4-aminophenoxy)phenyl]methane, bis[3-chloro-4-(4-aminophenoxy)phenyl]methane, bis[3,5-dimethyl-4-(4-aminophenoxy) phenyl]methane, 1,1-bis[4-(4-aminophenoxy)phenyl]ethane, 1,1-bis[3-methyl-4-(4-aminophenoxy)phenyl]ethane, 1,1-bis[3-chloro-4-(4-aminophenoxy)phenyl]ethane, 1,1-bis[3,5-dimethyl-4-(4-aminophenoxy)phenyl]ethane, 2,2-bis[4-(4-aminophenoxy)phenyl]propane, 2,2-bis[3-methyl-4-(4-aminophenoxy)phenyl]propane, 2,2-bis[3-chloro-4-(4-aminophenoxy)phenyl]propane, 2,2-bis[3,5-dimethyl-4-(4-aminophenoxy)phenyl]propane, 2,2-bis[4-(4-aminophenoxy)phenyl]butane, 2,2-bis[3-methyl-4-(4-aminophenoxy)phenyl]butane, 2,2-bis[3,5-dimethyl-4-(4-aminophenoxy)phenyl]butane, 2,2-bis[3,5-dibromo-4-(4-aminophenoxy)phenyl]butane, 1,1,1,3,3,3-hexafluoro-2,2-bis(4-aminophenoxy)propane, 1,1,1,3,3,3-hexafluoro-2,2-bis[3-methyl-4-(4-aminophenoxy)phenyl]propane, and a compound formed by substituting with a halogen atom or an alkyl group on an aromatic ring of any one of the above compounds. Two or more compounds out of the above aromatic diamine components may be used at the same time.

The aromatic diamine component is preferably selected from 1,3-phenylenediamine, 3,4'-diaminodiphenyl ether and 1,3-bis(3-aminophenoxy)benzene. Of these, 3,4'-diaminodiphenyl ether is particularly preferred for realizing low moisture absorption and low elastic modulus.

The film of this invention satisfies the following expressions (1) and (2).

$$CTE^{MD} \leqq -11 \times Mi^{MD} + 70 \quad (1)$$

$$CTE^{TD} \leqq -11 \times Mi^{TD} + 70 \quad (2)$$

wherein $CTE^{MD}$ is a coefficient of in-plane thermal expansion (ppm · $K^{-1}$) in the machine direction, $CTE^{TD}$ is a coefficient of in-plane thermal expansion (ppm · $K^{-1}$) in the transverse direction, $Mi^{MD}$ is an elastic modulus (GPa) in the machine

direction and $Mi^{TD}$ is an elastic modulus (GPa) in the transverse direction.

The expressions (1) and (2) denote that the coefficients of in-plane thermal expansion of the film are equivalent to, or smaller than, specific values defined by elastic moduli. When compared with conventional aromatic polyimide films, the film of this invention has smaller coefficients of in-plane thermal expansion while it has elastic moduli almost equivalent to those of the conventional polyimide films.

The film of this invention preferably satisfies the following expressions (1a) and (2a).

$$CTE^{MD} \leqq -11 \times Mi^{MD} + 67 \quad (1a)$$

$$CTE^{TD} \leqq -11 \times Mi^{TD} + 67 \quad (2a)$$

The film of this invention more preferably satisfies the following expressions (1b) and (2b).

$$CTE^{MD} \leqq -11 \times Mi^{MD} + 65 \quad (1b)$$

$$CTE^{TD} \leqq -11 \times Mi^{TD} + 65 \quad (2b)$$

As lower limits of CTE, a smaller value is preferred for bringing the thermal expansion coefficient of the film into agreement with those of various metal materials and realizing dimensional stability, while the lower limits of CTE are approximately as defined by the following expressions (1z) and (2z).

$$CTE^{MD} \geqq -11 \times Mi^{MD} + 45 \quad (1z)$$

$$CTE^{TD} \geqq -11 \times Mi^{TD} + 45 \quad (2z)$$

The elastic modulus Mi (GPa) can be measured by a known tensile test of a film. The coefficient of in-plane thermal expansion ($ppm \cdot K^{-1}$) can be measured by a known thermomechanical analysis.

Both $CTE^{MD}$ and $CTE^{TD}$ of the film of this invention are preferably approximately equivalent to the thermal expansion coefficient (18 $ppm \cdot K^{-1}$) of copper. That is, both $CTE^{MD}$ and $CTE^{TD}$ of the film of this invention are preferably 15 to 25 $ppm \cdot K^{-1}$, more preferably 16 to 23 $ppm \cdot K^{-1}$. When the $CTE^{MD}$ and $CTE^{TD}$ are brought into this range, there is produced an advantage that when the film of this invention is used in a state where it is bonded to copper, the distortion by a difference in thermal expansions caused by heating does not easily take place.

In the film of this invention, preferably, $|CTE^{MD} - CTE^{TD}|$ is 0 to 7 $ppm \cdot K^{-1}$. Both $Mi^{MD}$ and $Mi^{TD}$ of the film of this invention are preferably 0.5 to 7 GPa, more preferably 1 to 5 GPa.

In the film of this invention, preferably, the relationship between its refractive index (n) and its coefficient of in-plane thermal expansion (CTE) satisfies the following expressions (3) and (4).

$$CTE^{MD} \leqq -330 \times n^{MD} + 605 \quad (3)$$

$$CTE^{TD} \leqq -330 \times n^{TD} + 605 \quad (4)$$

wherein $CTE^{MD}$ is a coefficient of in-plane thermal expansion ($ppm \cdot K^{-1}$) in the machine direction, $CTE^{TD}$ is a coefficient of in-plane thermal expansion ($ppm \cdot K^{-1}$) in the transverse direction, $n^{MD}$ is a refractive index in the machine direction and $n^{TD}$ is a refractive index in the transverse direction. The refractive index (n) can be measured with a known Abbe's refractometer. The expressions (3) and (4) denote that the coefficients of in-plane thermal expansion of an aromatic polyimide film obtained are specific values defined by refractive index.

The film of this invention more preferably satisfies the following expressions (3a) and (4a).

$$CTE^{MD} \leqq -330 \times n^{MD} + 590 \quad (3a)$$

$$CTE^{TD} \leqq -330 \times n^{TD} + 590 \quad (4a)$$

In the film of this invention, both $n^{MD}$ and $n^{TD}$ are preferably 1.700 to 1.800, more preferably 1.720 t 1.780.

In the film of this invention, the arithmetic mean of the coefficients of in-plane thermal expansions (CTE) in the machine and transverse directions, i.e., $(CTE^{MD}+CTE^{TD})/2$, is preferably 5 to 25 ppm · $K^{-1}$, more preferably 8 to 23 ppm · $K^{-1}$, till more preferably 12 to 22 ppm · $K^{-1}$.

The in-plane orientation coefficient of the film of this invention is preferably 0.125 to 0.15, more preferably 0.126 to 0.145, still more preferably 0.1286 to 0.141. The in-plane orientation coefficient can be determined on the basis of a difference between an average of refractive indices of a film in the machine and transverse directions and a refractive index in the thickness direction.

Further, in the film of this invention, preferably, the difference ($\Delta n$) between its maximum refractive index $n^{Max}$ and its minimum refractive index $n^{Min}$ in the plane thereof is 0.05 or less. The maximum refractive index ($n^{Max}$) or the minimum refractive index ($n^{Min}$) generally corresponds to one of the machine (running) direction of the film or the direction perpendicular thereto, and when the direction in which the film exhibits a maximum refractive index ($n^{Max}$) is the machine direction, the direction in which the film exhibits a minimum refractive index ($n^{Min}$) is the transverse direction. Further, when the direction in which the film exhibits a maximum refractive index ($n^{Max}$) is the transverse direction, the direction in which the film exhibits a minimum refractive index ($n^{Min}$) is the machine direction. $\Delta n$ shows that with a decrease in its value, the anisotropy of physical properties in the plane of the film becomes smaller. For example, when the film is bonded to a copper foil, etc., a smaller $\Delta n$ is preferred for keeping physical properties such as a thermal expansion coefficient, Young's modulus, etc., from being different depending upon directions of the film. $\Delta n$ is 0 when there is no anisotropy, and a smaller $\Delta n$ is preferred. It is suitably 0.03 or less, more preferably 0.02 or less, still more preferably 0.015 or less.

The average thickness of the film of this invention is preferably 0.5 to 20 $\mu$m, more preferably 1 to 15 $\mu$m, still more preferably 1.5 to 12 $\mu$m, particularly preferably 2 to 8 $\mu$m. The average thickness can be determined by cutting from a film a sample in the form of a square whose sides are 16 cm long each, equivalently measuring it in 9 places and averaging measurement data.

<Process for the production of aromatic polyimide film>

The aromatic polyimide film of this invention can be produced by steps (1) to (5).

[Step (1)]

The step (1) is the step of reacting an aromatic tetracarboxylic acid (component A) containing at least 70 mol% of pyromellitic anhydride and an aromatic diamine (component B) containing at least 70 mol% of 4,4'-diaminodiphenyl ether, in an organic solvent, in the range of 0.95≤component A/component B≤1.05 by molar ratio, to obtain a dope of a polyamic acid containing at least 70 mol% of a recurring unit derived from the pyromellitic acid and the 4,4'-diaminodiphenyl ether.

The aromatic tetracarboxylic acid as a component A is as already explained in the section of the aromatic polyimide film. The component A contains a pyromellitic anhydride alone or contains a combination of a pyromellitic anhydride with other aromatic tetracarboxylic acid different from the pyromellitic anhydride. The content of the pyromellitic anhydride in the component A is at least 70 mol%, preferably 80 to 100 mol%, more preferably 90 to 100 mol%.

The aromatic diamine as a component B is similarly as already explained in the section of the aromatic polyimide film. The component B contains 4,4'-diaminodiphenyl ether alone or contains a combination of 4,4'-diaminodiphenyl ether with other aromatic diamine different from the 4,4'-diaminodiphenyl ether. The content of 4,4'-diaminodiphenyl ether in the component B is at least 70 mol%, preferably 80 to 100 mol%, more preferably 90 to 100 mol%.

The molar ratio of the components A and B is required to satisfy 0.95≤component A/component B≤1.05. When the value of the component A/component B is less than 0.95 or greater than 1.05, the reactivity in the polymerization of the aromatic polyamic acid is insufficient, and it may take a long time to obtain an aromatic polyamic acid having a sufficient viscosity, or an aromatic polyamic acid composition solution having a sufficient viscosity may not be obtained. The value of the component A/component B is preferably from 0.97 to 1.03, more preferably from 0.99 to 1.01.

The organic solvent to be used for the reaction is preferably selected from aprotic polar solvents such as N-methyl-2-pyrrolidone (to be sometimes referred to as "NMP" hereinafter), N,N-dimethylacetamide, N,N-dimethylformamide and dimethylimidazolidinone.

The order and method of adding the components A and B are not specially limited. Preferably, there may be employed a method in which the component B is first dissolved in an organic solvent and then the component A is added at a desired temperature to carry out the polymerization. The component A may be added in a specified amount at one step or may be divided and added a plurality of times. In particular when it is difficult to control the reaction temperature due to heat of the reaction, it is preferred to divide the component A to add its divisions a plurality of times.

The polymerization temperature is preferably between -20°C and 90°C, more preferably between -10°C and 80°C, still more preferably between 0°C and 70°C. When the polymerization temperature is lower than -20°C, no sufficient reaction rate can be obtained. When it is higher than 90°C, imidation partially takes place or a side reaction takes place, so that the aromatic polyamic acid sometimes cannot be stably obtained. Although differing depending upon the polymerization temperature, the reaction time period is generally 1 to 10 hours.

The polyamic acid obtained in step (1) contains at least 70 mol%, preferably 80 to 100 mol%, more preferably 90 to 100 mol%, of a recurring unit derived from pyromellitic acid and 4,4'-diaminodiphenyl ether.

In the step (1), the concentration of the polyamic acid in the obtained dope is preferably 0.1 to 40 % by weight, more preferably 0.5 to 30 % by weight, still more preferably 1 to 20 % by weight. When the concentration of the polyamic acid in the dope is too low, there is obtained no dope having a sufficient viscosity for forming a film. When it is too high, the dope has a high viscosity and is poor in film formability. The dope may be diluted with an organic solvent during the polymerization and/or after completion of the polymerization to adjust the concentration of the dope to be finally obtained.

The polyamic acid in the obtained dope may be terminal-blocked. When a terminal blocking agent is used for the terminal blocking, the terminal blocking agent preferably includes, for example, acid anhydride components such as phthalic anhydride and substituted compounds thereof, a hexahydrophthalic anhydride and a substituted compound thereof and succinic anhydride and substituted compound thereof and amine components such as aniline and a substituted compound thereof. Of these, phthalic anhydride and substituted compounds thereof and/or aniline and a substituted compound thereof are taken as particularly preferred examples. The time for adding the terminal blocking agent is not specially limited, and it may be added at any one of a time when a raw material is charged in the polymerization step, a time during the polymerization and a time of completion of the polymerization. The amount thereof can be an amount necessary for ensuring the termination of the substantial polymerization and the stabilization of the viscosity of the dope, and a suitable amount of the agent to be added can be determined by carrying out a simple experiment.

The reduced viscosity of the polyamic acid obtained in the above manner is preferably 1.5 to 30 dl/g, more preferably 2 to 25 dl/g, still more preferably 2.5 to 20 dl/g. When the reduced viscosity is less than 1.5 dl/g, the viscosity is insufficient and the dope is poor in film formability. When it is higher than 30 dl/g, the viscosity is too high and the dope is poor in film formability. The specific method of measurement for a reduced viscosity will be explained in detail in the description of Examples.

[Step (2)]

The step (2) is a step in which the dope obtained in the step (1) is cast on a support to obtain a cast film. The dope can be cast on a support such as a casting drum, a metal belt, a cast film formed of polyester or polypropylene, or the like with a die, an applicator or coater.

Desirably, the step (2) is carried out in a low-humidity atmosphere. The step (2) is preferably carried out in an atmosphere of an inert gas such as nitrogen or argon or in dry air, and of these, dry air is the most preferred from the viewpoint of an industrial production cost and the like.

The step (2) preferably comprises the step (2-i) of adding an imidation agent to the dope, the step (2-ii) of casting the dope on a support to obtain a cast film and the step (2-iii) of heating the cast film for preliminary gelling.

As an imidation agent that is added in the step (2-i), it is preferred to use a dehydrating agent and a ring-closing catalyst in combination. The dehydrating agent includes aliphatic acid anhydrides such as acetic anhydride. The ring-closing catalyst includes organic amine compounds. The organic amine compounds include tertiary aliphatic amines such as trimethylamine, triethylaminepyridine, tributylamine, diisopropylamine and triethylenediamine, aromatic amines such as N,N-dimethylaniline and 1,8-bis(N,N-dimethylamino)naphthalene, pyridine and pyridine derivatives thereof such as 4-(N,N-dimethyl)aminopyridine and picoline and derivatives thereof. Of these, pyridine, triethylenediamine, picoline and 4-(N,N-dimethyl)aminopyridine are preferred, and pyridine and triethylenediamine are particularly preferred.

The amount of the dehydrating agent per mole of the aromatic tetracarboxylic acid as a raw material is 0.1 to 15 mol, preferably 0.5 to 10 mol, more preferably 1 to 8 mol. The amount of the ring-closing catalyst per mole of the aromatic tetracarboxylic acid as a raw material is 0.1 to 20 mol, preferably 0.5 to 15 mol, more preferably 1 to 10 mol.

Regarding the order of addition of the ring-closing catalyst and the dehydrating agent, preferably, the ring-closing catalyst is added to the dope and thereafter the dehydrating agent is added. For keeping the imidation from taking place after the imidation agent is added to the dope and before a cast film is obtained by casting the dope on the

support, preferably, the dope and the cast film are maintained at a temperature of 0°C or lower in the steps (2-i) and (2-ii).

The step (2-ii) is the same as the above step (2).

The step (2-iii) is a step in which the cast film is heated to partially imidate the polyamic acid. The heating temperature can be a temperature at which the imidation sufficiently proceeds. The heating temperature is preferably 30 to 130°C, more preferably 40 to 120°C. When the heating temperature is too low, the imidation does not sufficiently proceed. When it is over 130°C, a side reaction is liable to take place. The time period for the heating is approximately 1 to 60 minutes. When the gel film is subjected to the above preliminary imidation, it is not required to carry out drastic imidation in the step (3) to be described later, and the imidation can be carried out stepwise, so that a film having excellent surface properties can be obtained.

[Step (3)]

The step (3) is a step in which the cast film is immersed in a coagulating liquid containing an imidation agent at 20 to 70°C, and the polyamic acid is thereby imidated to obtain a gel film.

The imidation agent can be selected from those explained with regard to the above step (2-i). That is, it is preferred to use a combination of a dehydrating agent and a ring-closing catalyst as an imidation agent. The dehydrating agent includes aliphatic acid anhydrides such as acetic anhydride and the like. The ring-closing catalyst includes organic amine compounds such as pyridine, triethylamine and the like.

When the preliminary imidation in the steps (2-i) to (2-iii) is not carried out, the concentration of the dehydrating agent in the coagulating liquid is preferably 1 to 70 vol%, more preferably 5 to 50 vol%, still more preferably 10 to 40 vol%. The concentration of the ring-closing catalyst is preferably 1 to 70 vol%, more preferably 5 to 50 vol%, still more preferably 10 to 40 vol%.

When the preliminary imidation in the steps (2-i) to (2-iii) is carried out, the concentration of the dehydrating agent in the coagulating liquid is preferably 1 to 70 vol%, more preferably 5 to 50 vol%, still more preferably 10 to 40 vol%. The concentration of the ring-closing catalyst is preferably 1 to 70 vol%, more preferably 5 to 50 vol%, still more preferably 10 to 40 vol%.

The total amount of the dehydrating agent that is used for the imidation in the steps (2) and (3), per mole of the aromatic tetracarboxylic acid as a raw material, is preferably 1 to 30 mol, more preferably 1 to 10 mol, still more preferably 4 to 8 mol. The same can be said with regard to the amount of the ring-closing catalyst. That is, the amount of the ring-closing catalyst per mole of the aromatic tetracarboxylic acid as a raw material is preferably 1 to 30 mol, more preferably 1 to 10 mol, still more preferably 4 to 8 mol.

The coagulating liquid may contain an organic solvent in addition to the ring-closing catalyst and the dehydrating agent. The organic solvent includes aprotic polar organic solvents such as N-methyl-2-pyrrolidone (NMP), N,N-dimethylacetamide, N,N-dimethylformamide, dimethylimidazolidinone and the like and non-reactive organic solvents such as xylene, toluene and the like. For adjusting the property of coagulation, the degree of swelling and the rate of drying, there may be added solvents having different gel-swelling capabilities. In this case, the amount of the solvents is approximately 30 vol% at the largest. Further, the solvents are limited to those that are non-reactive with the dehydrating agent and the ring-closing catalyst.

While the method of the immersion is not specially limited, preferably, the cast film is immersed in the coagulating liquid which is in a circulation state. The time period for the immersion is preferably 10 seconds or more, more preferably 1 minute or more, still more preferably 3 minutes or more. The upper limit thereof is not specially limited, while it is approximately 3 hours. The temperature of the coagulating liquid is 20 to 70°C, preferably 30 to 60°C.

The step (3) may be followed by the procedure of immersing the gel film in an organic solvent solution containing an imidation agent. In this case, preferably, the gel film is immersed in the organic solvent solution in a state where it is separated from the support. The solvent used for the immersion is preferably the organic solvent that is used in the polymerization or a mixture of the organic solvent that is used in the polymerization and other organic solvent. Examples of the "other" organic solvent include hydrocarbon solvents such as toluene and xylene and halogen-containing solvents such as methylene chloride and dichloroethane.

After the step (3), preferably, the gel film is immersed and washed in an organic solvent as required. The organic solvent for the washing includes aprotic organic polar solvents such as NMP, N,N-dimethylacetamide, N,N-dimethylformamide and dimethylimidazolidinone, aromatic hydrocarbons such as toluene, aliphatic alcohols such as isopropyl alcohol, benzyl alcohol, ester organic solvents and ketone organic solvents.

When a gel film is obtained by using dialkylcarbodiimide, the content of isoimido groups in the gel film is large, and it is preferred to fully wash the gel film with toluene, etc., for efficiently producing a stretching and orientation effect in the step (4). Further, the washing of the gel film is also important for removing dialkylurea formed together with the imidation. When a gel film is obtained by using an aliphatic acid anhydride and an organic amine, the content of imido groups in the gel film is large, and it is hence preferred to wash the gel film with the same organic solvent as the solvent that is used in the polymerization. Further, the gel film may be washed when the gel film is on a support, after it is

separated from the support or after it is stretched. Further, the gel film may be washed a plurality of times at any or each time of these.

The ge1 film obtained in the step (3) is a homogeneous, highly swollen and excellently stretchable film, and it can be oriented to a high degree by stretching in the step (4).

In the step (3), the cast film is imidated to ensure that the imidation index of an obtained gel film, represented by the following equation (ii), is preferably 0.6 to 1.2, more preferably 0.7 to 1.2.

$$\text{Imidation index} = Ab_{(1379)}/Ab_{(1502)} \quad (ii)$$

wherein $Ab_{(1379)}$ is an absorption intensity of a peak at 1,379 $cm^{-1}$ derived from an imido bond of the gel film, and $Ab_{(1502)}$ is an absorption intensity of a peak at 1,502 $cm^{-1}$ derived from a benzene ring, when a gel film is measured with an infrared spectrometer. For accomplishing the above imidation index, the gel film may be again immersed in the coagulating liquid containing a ring-closing catalyst and a dehydrating agent as already described.

The swelling degree of the gel film to be biaxially stretched is preferably 200 to 10,000 %, more preferably 250 to 9,000 %, still more preferably 300 to 8,000 %. When the swelling degree is low, no sufficient stretchability can be obtained in some cases. When the swelling degree is too high, it is sometimes difficult to subject the gel film to the stretching step since no sufficient self-suportability can be obtained.

According to the production process of this invention, the imidation index of the gel film is brought into a predetermined value, whereby the degree of freedom to select stretch ratios in the machine and transverse directions is improved in the step (4) that comes thereafter, and as a result there can be obtained a film that is highly oriented and has a small coefficient of in-plane thermal expansion.

According to the production process of this invention, further, the swelling degree of the gel film is brought into a predetermined value in addition to the imidation index, whereby the stretching is smoothly carried out in the step (4) that comes thereafter, and as a result, there can be obtained a film that is highly oriented and has a small coefficient of in-plane thermal expansion.

[Step (4)]

The step (4) is a step in which the gel film is stretched at least 1.4 times as large in each of the machine and transverse directions, to obtain a biaxially stretched gel film.

The machine direction (MD) refers to the direction in which a film is taken up when it is stretched, and it is also called the length direction. The transverse direction (TD) refers to the direction that is at right angles with the machine direction and it is also called the width direction.

The stretch ratio in each of the machine and transverse directions is at least 1.4 times, preferably at least 1.6 times, more preferably 1.9 times, still more preferably at least 2.5 times. The stretch ratio in the machine direction and the stretch ratio in the transverse direction may be the same or may be different from each other. When the gel film is stretched at least 1.4 times as large in each direction, there can be produced an aromatic polyimide film that satisfies the expressions (1) and (2). A higher stretch ratio is preferred for obtaining an aromatic polyimide film that satisfies the expressions (1) and (2).

The upper limit of each stretch ratio is preferably 10 times, more preferably 7 times, still more preferably 5 times, particularly preferably 3 times. Although not specially limited, the stretching temperature is preferably -10 to 100°C, more preferably -5 to 90°C, still more preferably 0°C to 80°C. For the stretching, there may be employed any one of a consecutive-stretching method and a simultaneous biaxially stretching method. Further, the stretching may be carried out in any one of an atmosphere of a solvent, an atmosphere of air or an inert atmosphere. Carrying out the stretching in air is a particularly preferred example.

[Step (5)]

The step (5) is a step in which the biaxially stretched gel film is dried and heat-treated. The drying can be carried out by causing dry air to flow on the film surface with a hot air dryer or the like. The temperature of the dry air is preferably 250 to 270°C, at which the organic solvent is volatilized. The heat treatment is carried out by heating with hot air, vacuum contact heating, infrared ray heating, microwave heating or heating with a hot plate or hot roll. In this case, the imidation can be proceeded with by increasing the temperature stepwise.

The heat treatment is preferably carried out while the biaxially stretched gel film has a constant length or is under tension. The heat treatment temperature is preferably 250 to 550°C, more preferably 300 to 500°C, still more preferably 330 to 480°C. The heat treatment may be also carried out by gradually increasing or decreasing the temperature

at multi-steps. By the heat treatment, an aromatic polyimide film can be obtained while suppressing the relaxation of orientation. When the temperature for the heat treatment is lower than 250°C, the imidation ratio is insufficient and a film obtained is poor in thermal stability, in particular in dimensional stability. When the heat treatment is carried out at a temperature higher than 550°C, the aromatic polyimide may sometimes undergo thermal deterioration.

The film of this invention may contain various additives as required so long as the film is not impaired in properties. These additives include fibrous reinforcement materials such as a glass fiber, a metal fiber, an aramid fiber, a ceramic fiber, a potassium titanate whisker, a barium titanate whisker, a carbon fiber and carbon nano-tubes, fillers such as talc, calcium carbonate, mica, clay, titanium oxide, aluminum oxide, glass fine particles, glass flakes, a milled fiber, metal flakes and a metal powder, thermal or oxidation stabilizers typified by phosphoric ester and phosphite ester, a light stabilizer, an ultraviolet absorbent, a lubricant, a pigment, a flame-retarding agent, a plasticizer, a crystal nucleating agent and the like. The amount of these is not specially limited, while it is preferably in a range in which the film is not degraded in properties, for example, up to, or smaller than, 20 % by weight. Further, the film may be subjected to conventionally known surface modification, such as sand blasting, surface plasma treatment, corona treatment, treatment with a silane coupling agent, or the like as required depending upon purposes such as an improvement in the property of surface bonding.

Examples

This invention will be specifically explained hereinafter with reference to Examples, while the scope of this invention shall not be limited by these Examples. In this invention, measurements of physical properties and evaluations of effects were made according to the following methods.

(1) Reduced viscosity

A reduced viscosity of a polyamic acid was calculated from a result obtained by measurement using a solution of 0.05 g/dL of the polyamic acid in a 1 wt% lithium chloride/NMP solution as a dissolving liquid, at a temperature of 0°C.

(2) Swelling degree

A swelling degree was calculated from a weight (Ww) in a swollen state and a weight (Wd) in a dry state according to the following equation (i).

$$\text{Swelling degree (wt\%)} = (Ww/Wd - 1) \times 100 \qquad \text{(i)}$$

(3) Elastic modulus (Young's modulus), tensile strength and breaking elongation percentage

A 50 mm x 10 mm sample was measured for an elastic modulus, tensile strength and a breaking elongation percentage at a tension rate of 5 mm/minute with an ORIENTEC UCT-IT.

(4) Imidation index

For an imidation index, a film was measured with a Fourier transform infrared spectrometer (Nicolet Magna 750) according to a multipath reflection method, and the imidation index was calculated from an absorption intensity ($Ab_{(1379)}$) of a peak at 1,379 $cm^{-1}$ derived from an imido bond and an absorption intensity ($Ab_{(1502)}$) of a peak at 1,502 $cm^{-1}$ derived from a benzene ring according to the following equation (ii).

$$\text{Imidation index} = Ab_{(1379)} / Ab_{(1502)} \qquad \text{(ii)}$$

(5) Coefficient of in-plane thermal expansion (CTE)

For a coefficient of in-plane thermal expansion (CTE), a 13 mm ($L_0$) x 4 mm sample was measured for amounts $\Delta L$ of changes in sample length between 100°C and 200°C with a TMA 2940 thermomechanical analyzer of TA Instruments while the temperature was increased and decreased at a temperature elevation rate of 10°C/minute in the range between 50°C and 250°C, and the coefficient of in-plane thermal expansion (CTE) was calculated according to the following

equation (iii).

$$CTE(ppm \cdot K^{-1}) = 10{,}000 \times \Delta L/L_0 \quad (iii)$$

(6) Average CTE

An average CTE was obtained as an average value of CTEs (ppm · $K^{-1}$) in the MD and TD directions, according to the following equation (iv).

$$\text{Average CTE} = (CTE^{MD} + CTE^{TD})/2 \quad (iv)$$

(7) Refractive index

A refractive index was measured at a wavelength of 589 nm with an ATAGO multiple wavelength Abbe's refractometer.

(8) In-plane orientation coefficient

An in-plane orientation coefficient of an aromatic polyimide film was calculated on the basis of the following expression (v).

(Refractive index in the machine direction + refractive index in the transverse direction)/2 - refractive index in the thickness direction (v)

(9) Average thickness

A film was cut to obtain a sample having the form of a square whose sides were 16 cm long each, the sample was equivalently measured in 9 places and measurement data were averaged. As a measuring apparatus, LITEMATIC VL-50 (supplied by Mitutoyo Corporation) was used.

Example 1

(Step (1))

A reactor having a thermometer, a stirrer and a feed port was charged with 1,100 mL of dehydrated N,N-dimethylacetamide (to be referred to as "DMAc" hereinafter) in a nitrogen atmosphere, and further 119.8 g of 4,4'-diphenyldiamoether was added and dissolved therein. Then, the diamine solution was temperature-adjusted to 20°C, 129.5 g of pyromellitic anhydride was divided to a plurality of parts and added to the diamine solution stepwise, and the mixture was allowed to react at 20 to 40°C for 1 hour. Further, it was allowed to react at 60°C for 2 hours and 30 minutes to give a viscous dope. The dope contained a polyamic acid as a solute and DMAc as an organic solvent and had a polyamic acid concentration of 18 % by weight. The polyamic acid was found to be composed of a recurring unit derived from 4,4'-diphenyldiaminoether and pyromellitic acid.

(Step (2))

The thus-obtained dope was cast on a PET film as a support with a doctor blade so as to give a thickness of 500 μm, whereby a cast film was obtained.

(Step (3))

The cast film on the PET film was immersed in a dehydrating coagulating bath containing 1,050 ml of acetic

anhydride, 450 ml of pyridine and 1,500 ml of DMAc at 30°C for 8 minutes for imidation. Then, the cast film was separated from the PET film and washed by immersing it in DMAc at room temperature for 20 minutes, to give a gel film. The thus-obtained gel film had an imidation index of 0.8 and a swelling degree of 350 %.

(Step (4))

Then, both ends of the gel film were gripped and it was simultaneously biaxially stretched 2.48 times as large each in the machine direction (MD) and the width direction (TD) at a rate of 10 mm/second at room temperature.

(Step (5))

The stretched gel film was fixed on a frame and dried by causing the flow of dry air at 260°C with a hot air dryer for 20 minutes. Then, in a hot air circulating oven, the gel film was temperature-increased stepwise from 300 to 450°C over 10 minutes to give a film. Table 1 shows the elastic moduli (Mi), tensile strengths, breaking elongation percentages, coefficients of in-plane thermal expansion (CTE), an average coefficient of in-plane thermal expansion (average CTE), plane orientation coefficient and refractive indices (n) of the thus-obtained film. The film had an average CTE of 19.4 ppm · $K^{-1}$, and regarding the relationship between the elastic modulus Mi (GPa) and CTE (ppm · $K^{-1}$), it was found that the film satisfied the following expressions (1) and (2).

$$CTE^{MD} \leqq -11 \times Mi^{MD} + 70 \qquad (1)$$

$$CTE^{TD} \leqq -11 \times Mi^{TD} + 70 \qquad (2)$$

Regarding the relationship between the refractive index (-) and CTE (ppm · $K^{-1}$), it was found that the film satisfied the following expressions (3) and (4).

$$CTE^{MD} \leqq -330 \times n^{MD} + 605 \qquad (3)$$

$$CTE^{TD} \leqq -330 \times n^{TD} + 605 \qquad (4)$$

Example 2

(Step (1))

A reactor having a thermometer, a stirrer and a feed port was charged with 23.5 L of dehydrated DMAc in a nitrogen atmosphere, and further 2.33 kg of 4,4-diphenyldiaminoether was added and dissolved therein. Then, the diamine solution was temperature-adjusted to 20°C, 2.521 kg of pyromellitic anhydride was divided to a plurality of parts and added to the diamine solution stepwise, and the mixture was allowed to react for 1 hour. In this case, the reaction temperature was at 20 to 40°C. Further, the reaction temperature was increased to 60°C, and it was allowed to react for 5 hours and 30 minutes to give a viscous dope.

The dope contained a polyamic acid as a solute and DMAc as an organic solvent and had a polyamic acid concentration of 18 % by weight. The polyamic acid was found to be composed of a recurring unit derived from 4,4'-diphenyldiaminoether and pyromellitic acid.

(Step (2))

To the thus-obtained dope was added 1.35 L of pyridine as a ring-closing catalyst. This amount corresponds to a polyamic acid recurring unit (mol) /pyridine (mol) = 1/1.5 in the dope.

Then, the dope containing pyridine was passed at 23.3 ml/minute with a gear pump into a tube cooled to -10°C, and introduced into a static mixer placed midway in the tube between the reactor and a T die. The reactor side of the Φ6.5 static mixer having 48 elements was taken as stage 0 and the element on the T die side was taken as stage

48. Acetic anhydride was fed to the stage 0 at a rate of 1.8 ml/minute and mixed with the dope. This rate corresponds to the polyamic acid recurring unit (mol)/pyridine (mol)/acetic anhydride (mol) = 1/1.5/2 in the dope.

The dope having a temperature of -10°C, which was passed via the static mixer, was cast on a PET film through the T die having a lip opening of 400 μm and a width of 320 mm in a casting vessel under a nitrogen atmosphere, and the resultant casting product was preheated at 50°C to give a pre-imidated gel film.

(Step (3))

Then, the gel film on the PET film was introduced into a dehydrating coagulating bath at 0.2 m/minute for imidation. The coagulating liquid had been prepared by mixing 1,050 ml of acetic anhydride, 450 ml of pyridine and 1,500 ml of DMAc. The coagulating liquid had a temperature set at 60°C.

Then, the imidated gel film was dried with dry nitrogen having a water concentration of 40 ppm for 10 minutes. The dry nitrogen was caused to flow from a blowing port positioned 7.5 cm apart from the gel film surface toward a discharge port opposed to the blowing port, in parallel with the gel film surface. The dry nitrogen was caused to flow at an average flow rate of 20 cm/second in a manner that the product of an average flow rate and a blowing distance was 150 $cm^2$/second. Then, the gel film was washed with a DMAc solution. The gel film had an imidation index of 0.82 and a swelling degree of 268 %.

(Step (4))

Then, both ends of the gel film was fixed with chucks, and the gel film was simultaneously biaxially stretched 1.8 times as large in the machine direction and 2.2 times as large in the transverse direction, at a rate of 10 mm/second.

(Step (5))

The stretched gel film was fixed on a frame and dried by causing the flow of dry air at 260°C with a hot air dryer for 20 minutes. Then, in a hot air circulating oven, the gel film was temperature-increased stepwise from 300 to 450°C over 10 minutes to give a film. Table 1 shows the elastic moduli (Mi), tensile strengths, breaking elongation percentages, coefficients of in-plane thermal expansion (CTE), an average coefficient of in-plane thermal expansion (average CTE), plane orientation coefficient and refractive indices (n) of the thus-obtained film.

The film had an average CTE of 20.3 ppm · $K^{-1}$, and it was found that CTE, Mi and n in each of the machine and transverse directions satisfied the following expressions (1) and (4).

$$CTE^{MD} \leqq -11 \times Mi^{MD} + 70 \quad (1)$$

$$CTE^{TD} \leqq -11 \times Mi^{TD} + 70 \quad (2)$$

$$CTE^{MD} \leqq -330 \times n^{MD} + 605 \quad (3)$$

$$CTE^{TD} \leqq -330 \times n^{TD} + 605 \quad (4)$$

Example 3

A film was obtained in the same manner as in Example 2 except that the stretch ratios in the machine direction and the transverse direction were changed to 2.0 and 2.4, respectively. A gel film before stretched had an imidation index of 0.82 and a swelling degree of 268 %.

Table 1 shows the elastic moduli (Mi), tensile strengths, breaking elongation percentages, coefficients of in-plane thermal expansion (CTE), an average coefficient of in-plane thermal expansion (average CTE), plane orientation coefficient and refractive indices (n) of the thus-obtained film. The film had an average CTE of 20.8 ppm · $K^{-1}$, and it was found that CTE, Mi and n in each of the machine and transverse directions satisfied the expressions (1) to (4).

Example 4

A film was obtained in the same manner as in Example 2 except that the carrying speed of a PET film was changed to 0.3 m/minute, that the gelling time period was changed to 6.7 minutes (a gel film had an imidation index of 0.71 and a swelling degree of 271 %) and that the stretch ratios in the machine direction and the transverse direction were changed to 1.7 and 2.1, respectively. Table 1 shows the elastic moduli (Mi), tensile strengths, breaking elongation percentages, coefficients of in-plane thermal expansion (CTE), an average coefficient of in-plane thermal expansion (average CTE), plane orientation coefficient and refractive indices (n) of the thus-obtained film. The film had an average CTE of 13.3 ppm · $K^{-1}$, and it was found that CTE, Mi and n in each of the machine and transverse directions satisfied the expressions (1) to (4).

Comparative Example 1

A film was obtained in the same manner as in Example 1 except that the stretch ratios in the machine direction and the transverse direction were changed to 1.39 and 1.61, respectively. A gel film before stretched had an imidation index of 0.82 and a swelling degree of 268 %.
Table 1 shows the elastic moduli (Mi), tensile strengths, breaking elongation percentages, coefficients of in-plane thermal expansion (CTE), an average coefficient of in-plane thermal expansion (average CTE), plane orientation coefficient and refractive indices (n) of the thus-obtained film. The film had an average CTE of 31 ppm · $K^{-1}$, and CTE, Mi and n in each of the machine and transverse directions did not satisfy the expressions (1) to (4).

Table 1

| | Unit | Direction | Ex. 1 | Ex. 2 | Ex. 3 | Ex. 4 | CEx. 1 |
|---|---|---|---|---|---|---|---|
| Stretch Ratio | times | MD | 2.5 | 1.8 | 2.0 | 1.7 | 1.39 |
| | times | TD | 2.5 | 2.2 | 2.4 | 2.1 | 1.61 |
| Film thickness | μm | - | 10 | 14.5 | 14.1 | 10.8 | 12.5 |
| Elastic modulus (Mi) | GPa | MD | 3.5 | 3.5 | 2.72 | 2.83 | 3.53 |
| | GPa | TD | 3.6 | 3.6 | 3.96 | 4.3 | 3.84 |
| Tensile Strength | MPa | MD | 305 | 353 | 260 | 225.8 | 289 |
| | MPa | TD | 309 | 368 | 362 | 418.6 | 303 |
| Breaking elongation Percentage | % | MD | 35 | 67.3 | 105.9 | 80.5 | 81 |
| | % | TD | 36 | 73.5 | 46 | 41.7 | 74 |
| Coefficient of in-plane Thermal expansion(CTE) | ppm · $K^{-1}$ | MD | 22.7 | 20.7 | 32.4 | 17.6 | 32.7 |
| | ppm · $K^{-1}$ | TD | 16.1 | 19.9 | 9.2 | 9.04 | 29.2 |
| Average CTE | ppm · $K^{-1}$ | - | 19.4 | 20.3 | 20.8 | 13.3 | 31 |
| In-plane orientation degree | - | - | 0.139 | 0.1396 | 0.139 | 0.1361 | 0.124 |
| Refractive index (n) | - | MD | 1.7454 | 1.7646 | 1.7282 | 1.7542 | 1.7434 |
| | - | TD | 1.7634 | 1.7525 | 1.772 | 1.7713 | 1.756 |
| Ex. = Example, CEx. = Comparative Example | | | | | | | |

Effect of the Invention

The film of this invention has excellent flexibility, has a small coefficient of in-plane thermal expansion and has excellent dimensional stability. The film of this invention is excellent in stability against changes in temperature. The film of this invention has a thermal expansion coefficient approximately equivalent to that of copper and has an advantage that it is causes almost no or little distortion caused by changes in temperature when used together with a copper foil to which it is bonded.
According to the process for the production of a film, provided by this invention, a gel film is stretched at high stretch ratios that no prior art has employed, in the machine direction and the transverse direction, so that the film obtained has a small coefficient of in-plane thermal expansion and is excellent in dimensional stability.

Industrial Utility

The film of this invention can be used as a support for an electric wiring board formed by stacking a copper foil thereon such as a flexible printed card, a support for a TAB (tape automated bonding) tape, a support for a tape for LOC (lead on chip) and the like.

## Claims

1. An aromatic polyimide film that is formed of an aromatic polyimide containing at least 70 mol% of a recurring unit of the following formula (I),

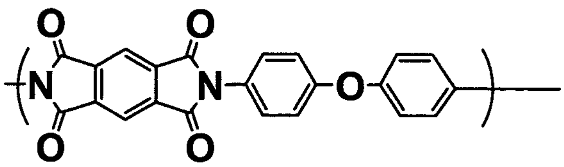

(I)

and that satisfies the following expressions (1) and (2),

$$CTE^{MD} \leqq -11 \times Mi^{MD} + 70 \quad (1)$$

$$CTE^{TD} \leqq -11 \times Mi^{TD} + 70 \quad (2)$$

wherein $CTE^{MD}$ is a coefficient of in-plane thermal expansion (ppm · $K^{-1}$) in the machine direction,
$CTE^{TD}$ is a coefficient of in-plane thermal expansion (ppm · $K^{-1}$) in the transverse direction,
$Mi^{MD}$ is an elastic modulus (GPa) in the machine direction, and
$Mi^{TD}$ is an elastic modulus (GPa) in the transverse direction.

2. The film of claim 1, which satisfies the following expressions (3) and (4),

$$CTE^{MD} \leqq -330 \times n^{MD} + 605 \quad (3)$$

$$CTE^{TD} \leqq -330 \times n^{TD} + 605 \quad (4)$$

wherein $n^{MD}$ is a refractive index in the machine direction and $n^{TD}$ is a refractive index in the transverse direction.

3. The film of claim 1, which satisfies $(CTE^{MD} + CTE^{TD})/2$ of 5 to 25 ppm · $K^{-1}$.

4. The film of claim 1, which has an in-plane orientation coefficient of 0.125 to 0.15.

5. The film of claim 1, wherein a difference between a maximum refractive index $n^{Max}$ and a minimum refractive index $n^{Min}$ in the plane of the film is 0.05 or less.

6. The film of claim 1, which has an average thickness of 0.5 to 20 μm.

7. A process for the production of an aromatic polyimide film of claim 1, which comprises the steps of:

(1) reacting an aromatic tetracarboxylic acid (component A) containing at least 70 mol% of pyromellitic anhydride

with an aromatic diamine (component B) containing at least 70 mol% of 4,4'-diaminodiphenyl ether, in an organic solvent, in the range of 0.95≤component A/component B (molar ratio)≤1.05, to obtain a dope of a polyamic acid containing at least 70 mol% of a recurring unit derived from the pyromellitic acid and the 4,4'-diaminodiphenyl ether,
(2) casting the dope on a support to obtain a cast film,
(3) immersing the cast film in a coagulating liquid containing an imidation agent at 20 to 70°C and thereby imidating the polyamic acid to obtain a gel film,
(4) stretching the gel film at least 1.4 times as long in the machine direction and at least 1.4 times as wide in the transverse direction, to obtain a biaxially stretched gel film, and
(5) drying and heat-treating the biaxially stretched gel film.

**8.** The process of claim 7, wherein the imidation agent of the step(3) is a combination of a ring-closing catalyst and a dehydrating gent.

**9.** The process of claim 8, wherein the ring-closing catalyst is an organic amine compound.

**10.** The process of claim 8, wherein the dehydrating agent is acetic anhydride.

**11.** The process of claim 7, wherein the gel film obtained in the step (3) has an imidation index of 0.6 to 1.2.

**12.** The process of claim 7, wherein the gel film obtained in the step (3) has a swelling degree of 200 to 10,000 %.

**13.** The process of claim 7, wherein the biaxially stretched gel film is dried and heat-treated in a manner of the step (5) while it has a constant length or is under tension in the step (5).

**14.** The process of claim 7, wherein the step (2) comprises the steps of (2-i) adding the imidation agent to the dope, (2-ii) casting the dope on the support to obtain a cast film and (2-iii) heating the cast film for its preliminary imidation.

**15.** The process of claim 14, wherein the imidation agent in the step (2-i) is a combination of a ring-closing catalyst and a dehydrating agent.

**16.** The process of claim 15, wherein the ring-closing catalyst is an organic amine compound.

**17.** The process of claim 15, wherein the dehydrating agent is acetic anhydride.

**18.** The process of claim 15, wherein the ring-closing catalyst is added to the dope and then the dehydrating agent is added in the step (2-i).

**19.** The process of claim 14, wherein the dope and the cast film are maintained a temperature of 0°C or lower in the steps (2-i) and (2-ii).

**INTERNATIONAL SEARCH REPORT**

International application No.
PCT/JP2006/306983

A. CLASSIFICATION OF SUBJECT MATTER
***C08J5/18***(2006.01), ***B29C41/24***(2006.01), ***B29C55/12***(2006.01), ***C08G73/10***
(2006.01), *B29K79/00*(2006.01), *B29L7/00*(2006.01), *C08L79/08*(2006.01)

According to International Patent Classification (IPC) or to both national classification and IPC

B. FIELDS SEARCHED

Minimum documentation searched (classification system followed by classification symbols)
B29C41/24-41/32, B29C55/12-55/16, B29K79/00, C08G73/10-73/16, C08J5/18

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2002-265643 A (Du Pont-Toray Co., Ltd.), 18 September, 2002 (18.09.02), Claims; Par. Nos. [0008], [0015], [0018] (Family: none) | 1-19 |
| Y | JP 2003-268135 A (Teijin Ltd.), 25 September, 2003 (25.09.03), Claims; Par. Nos. [0009], [0016], [0022], [0027] to [0031] (Family: none) | 1-19 |
| Y | JP 2003-145561 A (Teijin Ltd.), 20 May, 2003 (20.05.03), Claims; Par. Nos. [0016], [0018] (Family: none) | 1-19 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>25 May, 2006 (25.05.06) | Date of mailing of the international search report<br>06 June, 2006 (06.06.06) |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.
PCT/JP2006/306983

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-283077 A (Teijin Ltd.), 03 October, 2003 (03.10.03), Claims; Par. No. [0054] (Family: none) | 1-19 |
| E,A | JP 2006-083207 A (Du Pont-Toray Co., Ltd.), 30 March, 2006 (30.03.06), Par. No. [0036] (Family: none) | 1-19 |

Form PCT/ISA/210 (continuation of second sheet) (April 2005)

**INTERNATIONAL SEARCH REPORT**

International application No.
PCT/JP2006/306983

Claims 1 and 2 include a very large number of films having desired characteristics defined by the formulae (1)-(4). Although claims 1 and 2 include all the polyimide films having such characteristics, only a few films among the claimed films are disclosed by the description within the meaning of PCT Article 5. Consequently, claims 1 and 2 are not fully supported within the meaning of PCT Article 6.

Since the scope of such films having the characteristics of formulae (1)-(4) cannot be specified even by taking the common technical knowledge at the time of filing into consideration, claim 1 and 2 also fail to satisfy the requirement of clearness prescribed under PCT Article 6.

This international search report therefore covers the films (Examples 1-4) obtained by a production method which is specifically disclosed by the description.

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5237928 A